# EUROPÄISCHE PATENTSCHRIFT

(11) **EP 2 351 079 B1**
(45) Veröffentlichungstag und Bekanntmachung des Hinweises auf die Patenterteilung: **08.03.2017**
(21) Anmeldenummer: 09767932.8
(22) Anmeldetag: 29.10.2009
(51) Int. Cl.: H01L 25/16, H01L 27/15, H01L 33/38, H01L 33/08

(54) **STRAHLUNGSEMITTIERENDER HALBLEITERCHIP**
RADIATION-EMITTING SEMICONDUCTOR CHIP
PUCE SEMI-CONDUCTRICE ÉMETTANT UN RAYONNEMENT

(30) Priorität: 28.11.2008 DE 102008059580; 26.01.2009 DE 102009006177
(43) Veröffentlichungstag der Anmeldung: 03.08.2011
(73) Patentinhaber: OSRAM Opto Semiconductors GmbH, 93055 Regensburg (DE)
(72) Erfinder: MOOSBURGER, Jürgen, 93055 Regensburg (DE); VON MALM, Norwin, 93152 Nittendorf-Thumhausen (DE); RODE, Patrick, 93051 Regensburg (DE); HÖPPEL, Lutz, 93087 Alteglofsheim (DE); ENGL, Karl, 93080 Pentling (DE)
(74) Vertreter: Epping - Hermann - Fischer
(86) Internationale Anmeldenummer: PCT/DE2009/001524
(87) Internationale Veröffentlichungsnummer: WO 2010/060404

(56) Entgegenhaltungen:
- DE-A1-102007 022 947
- US-A1- 2005 167 680
- US-A1- 2006 163 604
- SHIH-CHANG SHEI ET AL: "Improved Reliability and ESD Characteristics of Flip-Chip GaN-Based LEDs With Internal Inverse-Parallel Protection Diodes" IEEE ELECTRON DEVICE LETTERS, IEEE SERVICE CENTER, NEW YORK, NY, US, Bd. 28, Nr. 5, 1. Mai 2007 (2007-05-01), Seiten 346-349, XP011179469 ISSN: 0741-3106

## Beschreibung

Die vorliegende Anmeldung betrifft einen strahlungsemittierenden Halbleiterchip.

Diese Patentanmeldung beansprucht die Priorität der deutschen Patentanmeldungen 10 2008 059 580.2 und 10 2009 006 177.0 .

Elektrostatische Entladung (electrostatic discharge, ESD) kann bei strahlungsemittierenden Halbleiterchips wie beispielsweise Leuchtdioden zur Schädigung bis hin zur Zerstörung führen. Die Gefahr einer solchen Schädigung kann durch eine zusätzliche Diode vermieden werden, wobei die Durchlassrichtung der Diode antiparallel zu der Durchlassrichtung des strahlungsemittierenden Halbleiterchips orientiert ist. Bei dieser Methode muss zusätzlich zu den strahlungsemittierenden Halbleiterchips also jeweils mindestens eine weitere Diode montiert werden, was zu erhöhtem Montageaufwand und Platzbedarf und damit verbundenen höheren Herstellungskosten führen kann.

In der Druckschrift DE 10 2007 022 947 A1 wird ein optoelektronischer Halbleiterkörper mit einer Halbleiterschichtenfolge, die eine zur Erzeugung von elektromagnetischer Strahlung geeignete aktive Schicht aufweist, und einer ersten und einer zweiten elektrischen Anschlussschicht angegeben, wobei der Halbleiterkörper zur Emission elektromagnetischer Strahlung von einer Vorderseite vorgesehen ist, und die erste und die zweite elektrische Anschlussschicht an einer der Vorderseite gegenüberliegenden Rückseite angeordnet sind. Über eine der Vorderseite benachbarte Pufferschicht soll die Gefahr einer Zerstörung des Halbleiterkörpers durch eine elektrostatische Entladung verringert werden.

Aus der Druckschrift US 2005/0167680 ist eine Licht emittierende Diodenstruktur mit einem Schutz vor elektrostatischer Entladung bekannt, bei der eine Halbleiterschicht in eine erste und eine zweite Inselstruktur unterteilt ist.

Eine Aufgabe ist es, einen strahlungsemittierenden Halbleiterchip anzugeben, der gegenüber elektrostatischer Entladung eine verringerte Empfindlichkeit aufweist. Weiterhin soll ein einfaches und zuverlässiges Verfahren zur Herstellung eines solchen Halbleiterchips angegeben werden.

Diese Aufgaben werden durch einen strahlungsemittierenden Halbleiterchip beziehungsweise durch ein Verfahren gemäß den unabhängigen Patentansprüchen gelöst. Weitere Ausbildungen und Zweckmäßigkeiten des Halbleiterchips beziehungsweise des Verfahrens sind Gegenstand der abhängigen Patentansprüche.

Gemäß einer Ausführungsform weist ein strahlungsemittierender Halbleiterchip einen Träger und einen Halbleiterkörper mit einer Halbleiterschichtenfolge auf. In dem Halbleiterkörper ist ein Emissionsbereich und ein, vorzugsweise vom Emissionsbereich separater, Schutzdiodenbereich gebildet. Die Halbleiterschichtenfolge umfasst einen zur Erzeugung von Strahlung vorgesehenen aktiven Bereich, der zwischen einer ersten Halbleiterschicht und einer zweiten Halbleiterschicht angeordnet ist. Die erste Halbleiterschicht ist auf der dem Träger abgewandten Seite des aktiven Bereichs angeordnet. Der Emissionsbereich weist zumindest eine Ausnehmung auf, die sich durch den aktiven Bereich hindurch erstreckt. Die erste Halbleiterschicht ist im Emissionsbereich elektrisch leitend mit einer ersten Anschlussschicht verbunden, wobei sich die erste Anschlussschicht in der Ausnehmung von der ersten Halbleiterschicht in Richtung des Trägers erstreckt. Die erste Anschlussschicht ist im Schutzdiodenbereich mit der zweiten Halbleiterschicht elektrisch leitend verbunden.

Mittels des Schutzdiodenbereichs ist eine Schutzdiode gebildet, die in dieser Ausführungsform in den Halbleiterchip, insbesondere in den Halbleiterkörper, integriert ist. Eine ungewünschte, etwa in Sperrrichtung am aktiven Bereich des Emissionsbereichs an dem Halbleiterchip anliegende, Spannung kann über den Schutzdiodenbereich abfließen. Der Schutzdiodenbereich kann also insbesondere die Funktion einer ESD-Diode erfüllen und muss im Unterschied zum Emissionsbereich nicht der Strahlungserzeugung dienen. Durch den Schutzdiodenbereich kann der Halbleiterchip vor einer Schädigung durch elektrostatische Entladung geschützt werden.

Insbesondere besteht dieser Schutz bereits vor der Montage des Halbleiterchips, etwa in einem Gehäuse für den Halbleiterchip oder auf einer Leiterplatte. Der Schutz ist also unabhängig von einer zusätzlichen, außerhalb des Halbleiterchips angeordneten und mit diesem elektrisch verbundenen Schutzdiode erzielbar.

Der Emissionsbereich und der Schutzdiodenbereich gehen vorzugsweise bei der Herstellung aus derselben Halbleiterschichtenfolge hervor. Auf die Abscheidung zusätzlicher Halbleiterschichten für die Ausbildung des Schutzdiodenbereichs kann also verzichtet werden.

Zweckmäßigerweise sind der aktive Bereich des Emissionsbereichs und der aktive Bereich des Schutzdiodenbereichs voneinander beabstandet.

Weiterhin sind der Emissionsbereich und der Schutzdiodenbereich vorzugsweise in lateraler Richtung, also entlang einer Haupterstreckungsebene der Halbleiterschichten des Halbleiterkörpers, nebeneinander angeordnet. Der Emissionsbereich und der Schutzdiodenbereich können also in lateraler Richtung nebeneinander angeordnete Bereiche des Halbleiterkörpers mit der Halbleiterschichtenfolge sein.

In einer bevorzugten Ausgestaltung ist zwischen dem Emissionsbereich und dem Schutzdiodenbereich eine Aussparung ausgebildet, die den Halbleiterkörper in zwei separate, voneinander lateral getrennte Bereiche teilt.

Über die erste Anschlussschicht sind die erste Halbleiterschicht im Emissionsbereich und die zweite Halbleiterschicht im Schutzdiodenbereich elektrisch leitend miteinander verbunden, wobei die erste Anschlussschicht vorzugsweise zur ersten Halbleiterschicht und zur zweiten Halbleiterschicht jeweils einen ohmschen Kontakt bildet.

Unter einem ohmschen Kontakt wird im Rahmen der Anmeldung insbesondere eine elektrische Verbindung verstanden, deren Strom-Spannungs-Kennlinie linear oder zumindest näherungsweise linear verläuft.

Die erste Halbleiterschicht und die zweite Halbleiterschicht des Halbleiterkörpers sind zweckmäßigerweise bezüglich ihres Leitungstyps voneinander verschieden. Beispielsweise kann die erste Halbleiterschicht p-leitend und die zweite Halbleiterschicht n-leitend ausgebildet sein oder umgekehrt.

Eine Diodenstruktur, in der der aktive Bereich ausgebildet ist, ist so auf einfache Weise realisiert.

In einer bevorzugten Ausgestaltung sind der Emissionsbereich und der Schutzdiodenbereich bezüglich ihrer Durchlassrichtung antiparallel zueinander verschaltet.

Weiterhin bevorzugt weist der Halbleiterchip einen ersten Kontakt und einen zweiten Kontakt auf. Der erste Kontakt und der zweite Kontakt können jeweils zur externen elektrischen Kontaktierung des Halbleiterchips vorgesehen sein. Vorzugsweise sind der Emissionsbereich und der Schutzdiodenbereich jeweils elektrisch leitend mit dem ersten Kontakt und dem zweiten Kontakt verbunden. Auf einen zusätzlichen externen Kontakt für den Schutzdiodenbereich kann also verzichtet werden. Mit anderen Worten kann der Halbleiterchip frei von einem zusätzlichen externen Kontakt ausgebildet sein, der von dem Emissionsbereich elektrisch isoliert ist und ausschließlich mit dem Schutzdiodenbereich elektrisch leitend verbunden ist.

Eine zwischen dem ersten Kontakt und dem zweiten Kontakt im Betrieb des strahlungsemittierenden Halbleiterchips anliegende Betriebsspannung bewirkt eine Injektion von Ladungsträgern von verschiedenen Seiten des aktiven Bereichs in den aktiven Bereich. Dort können die Ladungsträger unter Emission von Strahlung rekombinieren.

Durch den Schutzdiodenbereich, welcher bei der Betriebsspannung des Halbleiterchips in Sperrrichtung betrieben wird, erfolgt hierbei kein oder zumindest kein wesentlicher Stromfluss. Eine in Sperrrichtung an der Diodenstruktur des Emissionsbereichs anliegende elektrische Spannung, beispielsweise verursacht durch elektrostatische Aufladung, kann dagegen über die Schutzdiode abfließen. Der Emissionsbereich kann also durch eine in den Halbleiterchip, insbesondere in den Halbleiterkörper, integrierte Schutzdiode geschützt werden.

Die laterale Ausdehnung des Schutzdiodenbereichs ist vorzugsweise klein gegenüber der lateralen Ausdehnung des Halbleiterchips. Je kleiner die Fläche des Schutzdiodenbereichs ist, desto größer kann der zur Strahlungserzeugung beitragende Anteil des Emissionsbereichs an der Gesamtfläche des Halbleiterchips sein. Bevorzugt bedeckt der Schutzdiodenbereich höchstens 10 %, besonders bevorzugt höchstens 5 %, am meistens bevorzugt höchstens 1 % der Fläche des Halbleiterchips.

In einer bevorzugten Ausgestaltung ist der Halbleiterkörper stoffschlüssig mit dem Träger verbunden. Der Träger ist insbesondere von einem Aufwachssubstrat für die Halbleiterschichtenfolge des Halbleiterkörpers verschieden.

Bei einer stoffschlüssigen Verbindung werden die Verbindungspartner, die bevorzugt vorgefertigt sind, mittels atomarer und/oder molekularer Kräfte zusammengehalten. Eine stoffschlüssige Verbindung kann beispielsweise mittels einer Verbindungsschicht, etwa einer Klebeschicht oder einer Lotschicht erzielt werden. In der Regel geht eine Trennung der Verbindung mit der Zerstörung der Verbindungsschicht und/oder zumindest eines der Verbindungspartner einher.

In einer Ausgestaltungsvariante ist zumindest einer der Kontakte des Halbleiterchips kann auf der dem Halbleiterkörper abgewandten Seite des Trägers angeordnet. Die Injektion von Ladungsträgern in den Halbleiterkörper kann also durch den Träger hindurch erfolgen.

Die Injektion von Ladungsträgern kann flächig durch den Träger hindurch vom Kontakt in den Halbleiterkörper erfolgen. In diesem Fall ist der Träger vorzugsweise elektrisch leitfähig ausgebildet. Davon abweichend kann in dem Träger zumindest eine Aussparung ausgebildet sein, die sich vorzugsweise in vertikaler Richtung durch den Träger hindurch erstreckt und die zur elektrischen Kontaktierung des Halbleiterkörpers vorgesehen ist. In diesem Fall kann der Träger auch elektrisch isolierend ausgebildet sein. Die zumindest eine Aussparung ist zweckmäßigerweise mit einem elektrisch leitfähigen Material, beispielsweise einem Metall, befüllt.

In einer alternativen Ausgestaltungsvariante kann die vom Halbleiterkörper abgewandte Seite des Trägers frei von einem elektrischen Kontakt ausgebildet sein. Mit anderen Worten können beide elektrische Kontakte auf der dem Halbleiterkörper zugewandten Seite des Trägers angeordnet sein. In diesem Fall ist der Träger vorzugsweise elektrisch isolierend ausgebildet. Davon abweichend kann aber auch ein elektrisch leitfähiger Träger Verwendung finden.

In einer weiteren alternativen Ausgestaltungsvariante sind zumindest zwei Kontakte auf der dem Halbleiterkörper abgewandten Seite des Trägers angeordnet. Mit anderen Worten kann die Kontaktierung des Halbleiterchips ausschließlich von der dem Halbleiterkörper abgewandten Seite des Trägers her erfolgen. Beispielsweise kann in dem Träger für die elektrische Kontaktierung der ersten Anschlussschicht und für die elektrische Kontaktierung der zweiten Anschlussschicht jeweils zumindest eine Aussparung vorgesehen sein, die sich vorzugsweise jeweils in vertikaler Richtung durch den, vorzugsweise elektrisch isolierend ausgebildeten, Träger hindurch erstrecken.

Der Träger kann insbesondere der mechanischen Stabilisierung des Halbleiterkörpers mit dem Emissionsbereich und dem Schutzdiodenbereich dienen. Das Aufwachssubstrat für die Halbleiterschichtenfolge des Halbleiterkörpers ist hierfür nicht mehr erforderlich und kann vollständig oder zumindest bereichsweise entfernt sein.

Der Träger kann beispielsweise ein Halbleitermaterial, etwa Germanium oder Silizium, enthalten oder aus einem solchen Material bestehen. Zur Erhöhung der elektrischen Leitfähigkeit kann der Träger geeignet dotiert sein.

Ein elektrisch isolierender Träger kann beispielsweise eine Keramik, etwa Aluminiumoxid, Aluminiumnitrid oder Siliziumnitrid enthalten oder aus einem solchen Material bestehen.

Ein Halbleiterchip, bei dem das Aufwachssubstrat entfernt ist, wird auch als Dünnfilm-Halbleiterchip bezeichnet.

Ein Dünnfilm-Halbleiterchip, etwa ein Dünnfilm-Leuchtdioden-Chip, zeichnet sich insbesondere durch folgende charakteristische Merkmale aus:
- an einer zu einem Trägerelement, etwa dem Träger, hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert' scher Oberflächenstrahler und eignet sich von daher besonders gut für die Anwendung in einem Scheinwerfer.

In einer bevorzugten Ausgestaltung verläuft die erste Anschlussschicht bereichsweise zwischen dem Halbleiterkörper und dem Träger. Mittels der ersten Anschlussschicht ist die auf der dem Träger abgewandten Seite des aktiven Bereichs angeordnete erste Halbleiterschicht elektrisch kontaktierbar. Eine auf der dem Träger abgewandten Seite des Halbleiterköpers ausgebildete Strahlungsaustrittsfläche des Halbleiterchips kann somit frei von auf dem vorgefertigten Halbleiterkörper aufgebrachten Schichten zur elektrischen Kontaktierung des Halbleiterkörpers, insbesondere frei von einem externen elektrischen Kontakt des Halbleiterchips sein.

In einer bevorzugten Weiterbildung bedeckt die erste Anschlussschicht den Träger in Aufsicht auf den Halbleiterchip vollständig. Bei der Herstellung der ersten Anschlussschicht kann somit auf ein strukturiertes Aufbringen oder eine Strukturierung der bereits aufgebrachten Anschlussschicht verzichtet werden.

Die zweite Halbleiterschicht ist im Emissionsbereich mit einer zweiten Anschlussschicht elektrisch leitend verbunden. Die zweite Anschlussschicht kann insbesondere zumindest bereichsweise unmittelbar an die zweite Halbleiterschicht angrenzen.

Weiterhin bevorzugt ist mittels der zweiten Anschlussschicht im Emissionsbereich ein ohmscher Kontakt zur zweiten Halbleiterschicht gebildet. Die Injektion von Ladungsträgern in den Halbleiterkörper ist so vereinfacht.

In einer weiteren bevorzugten Ausgestaltung verläuft die zweite Anschlussschicht bereichsweise zwischen dem Halbleiterkörper und dem Träger. Somit können die erste Anschlussschicht und die zweite Anschlussschicht zwischen dem Halbleiterkörper und dem Träger ausgebildet sein.

Mittels der ersten und der zweiten Anschlussschicht können die erste Halbleiterschicht beziehungsweise die zweite Halbleiterschicht im Emissionsbereich von derselben Seite des Halbleiterkörpers her elektrisch kontaktiert werden. Eine Strahlungsaustrittsfläche des Halbleiterchips, die frei von externen elektrischen Kontakten ist, ist so auf einfache Weise realisiert.

Mit anderen Worten können der Emissionsbereich und der Schutzdiodenbereich mittels zweier Anschlussschichten antiparallel zueinander verschaltet sein, wobei die Anschlussschichten jeweils zumindest bereichsweise zwischen dem Halbleiterkörper und dem Träger verlaufen.

Die zweite Anschlussschicht verläuft bereichsweise zwischen dem Halbleiterkörper und der ersten Anschlussschicht, insbesondere zwischen dem Emissionsbereich und der ersten Anschlussschicht.

In einer bevorzugten Weiterbildung ist die zweite Anschlussschicht für die im aktiven Bereich erzeugte Strahlung reflektierend ausgebildet. Im Betrieb des Halbleiterchips vom aktiven Bereich in Richtung des Trägers abgestrahlte Strahlung kann so an der zweiten Anschlussschicht reflektiert werden und nachfolgend durch die Strahlungsaustrittsfläche aus dem Halbleiterchip austreten.

Die insgesamt aus dem Halbleiterchip austretende Strahlungsleistung kann so weitergehend maximiert sein.

In einer weiteren bevorzugten Weiterbildung ist die zweite Anschlussschicht im Schutzdiodenbereich elektrisch leitend mit der ersten Halbleiterschicht verbunden. Eine antiparallele Verschaltung des Emissionsbereichs und des Schutzdiodenbereichs bezogen auf deren Durchlassrichtung ist so auf einfache Weise realisierbar. Die antiparallele Verschaltung kann hierbei innerhalb des Halbleiterchips erfolgen. Mit anderen Worten kann die antiparallele Verschaltung vollständig in den Halbleiterchip integriert sein.

Weiterhin kann die Integration des ESD-Schutzes in den Halbleiterkörper unabhängig vom Träger erfolgen. Der Träger kann also weitgehend unabhängig von der Ausgestaltung des Schutzdiodenbereiches ausgebildet sein. Insbesondere kann der Träger in lateraler Richtung eben und/oder unstrukturiert sein.

Insbesondere können der Schutzdiodenbereich und die zur antiparallelen Verschaltung des Schutzdiodenbereichs mit dem Emissionsbereich vorgesehenen Anschlussschichten in vertikaler Richtung vollständig zwischen einer dem Halbleiterkörper zugewandten Hauptfläche des Trägers und der Strahlungsaustrittsfläche ausgebildet sein. Die Integration der Funktion einer Schutzdiode in den Halbleiterchip ist so auf einfache Weise herstellbar.

In einer Ausgestaltungsvariante weist der Schutzdiodenbereich eine weitere Ausnehmung auf, wobei sich die zweite Anschlussschicht weiterhin bevorzugt von der ersten Halbleiterschicht in der weiteren Ausnehmung in Richtung des Trägers erstreckt. Die erste Halbleiterschicht des Schutzdiodenbereichs ist also über die weitere Ausnehmung durch den aktiven Bereich hindurch elektrisch kontaktierbar.

Einer der Kontakte des Halbleiterchips, insbesondere der zweite Kontakt, ist zweckmäßigerweise für die externe elektrische Kontaktierung der zweiten Anschlussschicht vorgesehen. Beispielsweise kann der Kontakt, insbesondere der zweite Kontakt, als ein Bondpad für eine Drahtbondverbindung ausgestaltet sein.

Der Kontakt kann mittels einer von außerhalb des Halbleiterchips zugänglichen Fläche der zweiten Anschlussschicht gebildet sein.

Davon abweichend kann der Kontakt auch mittels einer Kontaktschicht gebildet sein, die zusätzlich zur zweiten Anschlussschicht vorgesehen sein kann. Hierbei ist die Kontaktschicht zweckmäßigerweise elektrisch leitend mit der zweiten Anschlussschicht verbunden und grenzt weiterhin bevorzugt zumindest bereichsweise unmittelbar an diese an.

In einer bevorzugten Weiterbildung bedeckt die Kontaktschicht zumindest bereichsweise eine den Schutzdiodenbereich in lateraler Richtung begrenzende Seitenfläche. In diesem Fall ist zur Vermeidung eines elektrischen Kurzschlusses der Diodenstruktur des Schutzdiodenbereichs zweckmäßigerweise eine Isolationsschicht zwischen der Kontaktschicht und der Seitenfläche ausgebildet.

Die Kontaktschicht kann den Schutzdiodenbereich seitlich auch vollständig bedecken. Bei einer Kontaktschicht, die für im aktiven Bereich erzeugte Strahlung undurchlässig ist, kann so vermieden werden, dass im Fall einer elektrostatischen Entladung Strahlung aus dem Schutzdiodenbereich austritt.

Bei dieser Ausgestaltungsvariante ist die erste Halbleiterschicht im Schutzdiodenbereich auf der dem Träger abgewandten Seite des Halbleiterkörpers mit der Kontaktschicht elektrisch leitend verbunden. Insbesondere kann die Kontaktschicht im Schutzdiodenbereich an die erste Halbleiterschicht unmittelbar angrenzen. Auf die Kontaktierung der ersten Halbleiterschicht des Schutzdiodenbereichs mittels der durch die weitere Ausnehmung verlaufenden zweiten Anschlussschicht kann somit verzichtet werden.

Weiterhin wird mittels dieser Kontaktschicht eine elektrisch leitende Verbindung über die zweite Anschlussschicht mit der zweiten Halbleiterschicht des Emissionsbereichs hergestellt. Eine antiparallele Verschaltung von Emissionsbereich und Schutzdiodenbereich ist so auf einfache Weise realisiert.

Weiterhin bevorzugt überdeckt der Kontakt den Schutzdiodenbereich in Aufsicht auf den Halbleiterchip zumindest bereichsweise. Insbesondere kann der, etwa als Bondpad ausgeführte, Kontakt den Schutzdiodenbereich vollständig überdecken. Mit anderen Worten kann der Schutzdiodenbereich unterhalb des Kontakts in den Halbleiterchip integriert sein. Der Schutzdiodenbereich ist somit in den Halbleiterchip integrierbar, ohne dass hierfür die Fläche des Emissionsbereichs zusätzlich verringert werden muss.

Alternativ können der Kontakt und der Schutzdiodenbereich in Aufsicht auf den Halbleiterchip nebeneinander angeordnet sein. In diesem Fall kann der Kontakt mittels der zweiten Anschlussschicht oder mittels der auf der zweiten Anschlussschicht angeordneten Kontaktschicht gebildet sein.

Weiterhin bevorzugt enthält der Halbleiterkörper, insbesondere der aktive Bereich, ein III-V-Halbleitermaterial. Mit III-V-Halbleitermaterialien können bei der Strahlungserzeugung hohe interne Quanteneffizienzen erreicht werden.

In einer bevorzugten Ausgestaltung ist der Halbleiterchip als ein Leuchtdioden-Halbleiterchip, insbesondere als ein Dünnfilm-Halbleiterchip, ausgeführt, der weiterhin bevorzugt zur Erzeugung inkohärenter oder teilkohärenter Strahlung vorgesehen ist.

Bei einem Verfahren zur Herstellung einer Mehrzahl von strahlungsemittierenden Halbleiterchips wird gemäß einer Ausführungsform eine Halbleiterschichtenfolge bereitgestellt, die einen zur Erzeugung von Strahlung vorgesehenen aktiven Bereich aufweist, der zwischen einer ersten Halbleiterschicht und einer zweiten Halbleiterschicht angeordnet ist. Die Halbleiterschichtenfolge wird vorzugsweise epitaktisch, etwa mittels MOVPE oder MBE, abgeschieden. Eine Mehrzahl von Ausnehmungen wird ausgebildet, die sich durch die zweite Halbleiterschicht und durch den aktiven Bereich hindurch erstrecken. Auf der Halbleiterschichtenfolge wird, insbesondere nach Abschluss der Abscheidung der Halbleiterschichtenfolge, eine erste Anschlussschicht ausgebildet, wobei die erste Anschlussschicht in den Ausnehmungen elektrisch leitend mit der ersten Halbleiterschicht verbunden wird und wobei die erste Anschlussschicht bereichsweise mit der zweiten Halbleiterschicht elektrisch leitend verbunden wird. Ein Verbund wird ausgebildet, der die Halbleiterschichtenfolge und einen Träger umfasst. Aus der Halbleiterschichtenfolge wird eine Mehrzahl von Emissionsbereichen und eine Mehrzahl von Schutzdiodenbereichen ausgebildet, wobei die Emissionsbereiche jeweils mindestens eine Ausnehmung aufweisen und in den Schutzdiodenbereichen jeweils die erste Anschlussschicht mit der zweiten Halbleiterschicht elektrisch leitend verbunden ist. Der Verbund wird in eine Mehrzahl von Halbleiterchips vereinzelt, wobei jeder Halbleiterchip zumindest einen Emissionsbereich und zumindest einen Schutzdiodenbereich aufweist.

Die einzelnen Verfahrensschritte müssen hierbei nicht notwendigerweise in der Reihenfolge der obigen Aufzählung durchgeführt werden.

Bei dem beschriebenen Verfahren geht bei dem Vereinzeln des Verbunds eine Mehrzahl von Halbleiterchips hervor, die jeweils einen Halbleiterkörper und einen Träger aufweisen. Der Halbleiterkörper umfasst jeweils einen Emissionsbereich und einen Schutzdiodenbereich. Die Halbleiterchips weisen also bereits einen integrierten Schutz vor ESD-Entladungen auf. Die Gefahr einer Schädigung der Halbleiterchips während der Montage der Halbleiterchips beispielsweise in Gehäusen von optoelektronischen Bauelementen oder auf Leiterplatten wird so weitestgehend vermindert.

In einer bevorzugten Ausgestaltung wird ein Aufwachssubstrat für die Halbleiterschichtenfolge, insbesondere vor dem Ausbilden der Mehrzahl von Emissionsbereichen und der Mehrzahl von Schutzdiodenbereichen aus der Halbleiterschichtenfolge, zumindest bereichsweise entfernt. Dies kann mechanisch, beispielsweise mittels Schleifens, Läppens oder Polierens und/oder chemisch, etwa mittels nasschemischen oder trockenchemischen Ätzens, erfolgen. Alternativ oder ergänzend kann auch ein Laser-Ablöseverfahren (laser lift-off) Anwendung finden.

Die erste Anschlussschicht wird vorzugsweise ausgebildet, bevor die Emissionsbereiche und die Schutzdiodenbereiche, etwa mittels nasschemischer oder trockenchemischer Strukturierung, aus der Halbleiterschichtenfolge gebildet werden. Insbesondere können die Emissionsbereiche und die Schutzdiodenbereiche von der Seite der Halbleiterschichtenfolge her ausgebildet werden, auf der sich ursprünglich das Aufwachssubstrat befand.

Die erste Anschlussschicht und/oder die zweite Anschlussschicht enthalten bevorzugt ein Metall, etwa Aluminium, Silber, Titan, Rhodium, Platin, Nickel oder Gold oder eine metallische Legierung mit zumindest einem der genannten Metalle. Weiterhin können die erste Anschlussschicht und/oder die zweite Anschlussschicht auch mehrschichtig ausgebildet sein.

Alternativ oder ergänzend kann die erste Anschlussschicht und/oder die zweite Anschlussschicht auch ein TCO-Material (Transparent Conductive Oxide), beispielsweise Indium-ZinnOxid (ITO) oder Zinkoxid enthalten.

Die erste und/oder die zweite Anschlussschicht können beispielsweise mittels eines Abscheideverfahrens wie Aufdampfens oder Aufsputterns auf der, zweckmäßigerweise vorgefertigten, Halbleiterschichtenfolge ausgebildet werden.

Das beschriebene Verfahren ist zur Herstellung eines weiter oben beschriebenen Halbleiterchips besonders geeignet. Im Zusammenhang mit dem Halbeiterchip genannte Merkmale können daher auch für das Verfahren herangezogen werden und umgekehrt.

Weitere Merkmale, Ausgestaltungen und Zweckmäßigkeiten ergeben sich aus der folgenden Beschreibung der Ausführungsbeispiele in Verbindung mit den Figuren.

Es zeigen:
Die Figuren 1A und 1B ein erstes Ausführungsbeispiel für einen strahlungsemittierenden Halbleiterchip in schematischer Aufsicht (Figur 1B) und zugehöriger Schnittansicht (Figur 1A) ;
Figur 2 eine schematische Darstellung der Strompfade in einem Halbleiterchip gemäß dem in den Figuren 1A und 1B dargestellten ersten Ausführungsbeispiel;
die Figuren 3A und 3B ein zweites Ausführungsbeispiel für einen strahlungsemittierenden Halbleiterchip in schematischer Aufsicht (Figur 3B) und zugehöriger Schnittansicht (Figur 3A) ;
Figur 4 eine schematische Darstellung der Strompfade in einem Halbleiterchip gemäß dem in den Figuren 3A und 3B dargestellten zweiten Ausführungsbeispiel; und
die Figuren 5A bis 5F ein Ausführungsbeispiel für ein Verfahren zur Herstellung eines strahlungsemittierenden Halbleiterchips anhand von jeweils in schematischer Schnittansicht dargestellten Zwischenschritten.

Gleiche, gleichartige oder gleich wirkende Elemente sind in den Figuren mit gleichen Bezugszeichen versehen.

Die Figuren und die Größenverhältnisse der in den Figuren dargestellten Elemente untereinander sind nicht als maßstäblich zu betrachten. Vielmehr können einzelne Elemente und insbesondere Schichtdicken zur besseren Darstellbarkeit und/oder zum besseren Verständnis übertrieben groß dargestellt sein.

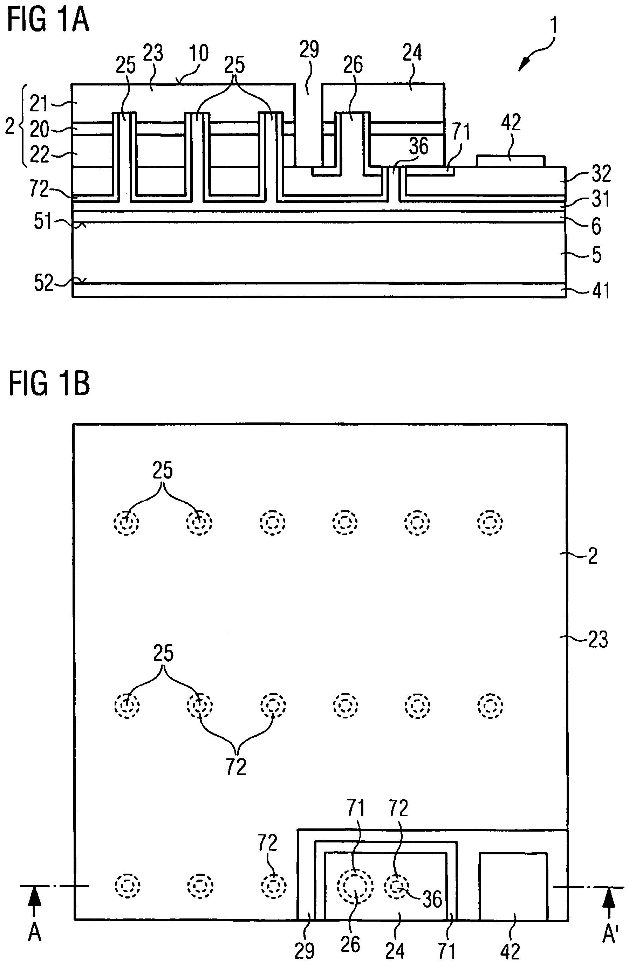

Ein erstes Ausführungsbeispiel für einen strahlungsemittierenden Halbleiterchip ist in Figur 1B in schematischer Aufsicht und in Figur 1A in zugehöriger schematischer Schnittansicht entlang der Linie AA' dargestellt.

Der Halbleiterchip 1 weist einen Halbleiterkörper 2 mit einer Halbleiterschichtenfolge und einen Träger 5 auf. Der Halbleiterkörper 2 weist einen Emissionsbereich 23 und einen Schutzdiodenbereich 24 auf. Der Emissionsbereich und der Schutzdiodenbereich sind in Aufsicht auf den Halbleiterchip überlappungsfrei nebeneinander angeordnet.

Der Emissionsbereich 23 und der Schutzdiodenbereich 24 sind mittels einer Aussparung 29 voneinander getrennt. Die Aussparung erstreckt sich in vertikaler Richtung, also in einer Richtung senkrecht zu einer Haupterstreckungsebene der Halbleiterschichten des Halbleiterkörpers 2 vollständig durch den Halbleiterkörper 2 hindurch. So ist eine elektrische Isolation des Schutzdiodenbereichs vom Emissionsbereich auf einfache Weise realisiert.

Die Halbleiterschichtenfolge, die den Halbleiterkörper 2 bildet, umfasst einen zur Erzeugung von Strahlung vorgesehenen aktiven Bereich 20, der zwischen einer ersten Halbleiterschicht 21 und einer zweiten Halbleiterschicht 22 angeordnet ist. Die erste Halbleiterschicht ist auf der vom Träger 5 abgewandten Seite des aktiven Bereichs angeordnet.

Auf der dem Träger 5 abgewandten Seite des Halbleiterkörpers 2 ist eine Strahlungsaustrittsfläche 10 des Halbleiterchips, insbesondere des Emissionsbereichs 23, gebildet. Im Betrieb des Halbleiterchips im aktiven Bereich des Emissionsbereichs erzeugte Strahlung tritt vorzugsweise überwiegend durch die Strahlungsaustrittsfläche aus dem Halbleiterchip 1 aus.

Die erste Halbleiterschicht 21 ist bezüglich des Leitungstyps von der zweiten Halbleiterschicht 22 verschieden. Beispielsweise kann die zweite Halbleiterschicht p-leitend und die erste Halbleiterschicht n-leitend ausgeführt sein oder umgekehrt.

Der aktive Bereich 20 ist somit in einer Diodenstruktur angeordnet.

Der Halbleiterkörper 2 mit dem Emissionsbereich 23 und dem Schutzdiodenbereich 24 ist mittels einer Verbindungsschicht 6 stoffschlüssig mit einer dem Halbleiterkörper zugewandten ersten Hauptfläche 51 des Trägers 5 verbunden. Die Verbindungsschicht kann beispielsweise eine Klebeschicht oder eine Lotschicht sein.

Zwischen dem Halbleiterkörper 2 und dem Träger 5 ist eine erste Anschlussschicht 31 ausgebildet. Im Emissionsbereich weist der Halbleiterkörper 2 eine Mehrzahl von Ausnehmungen 25 auf, die sich durch die zweite Halbleiterschicht 22 und durch den aktiven Bereich 20 in die erste Halbleiterschicht 21 hinein erstrecken. Die erste Anschlussschicht 31 verläuft durch die Ausnehmungen hindurch und stellt von der dem Träger zugewandten Seite des Halbleiterkörpers 2 her eine elektrisch leitende Verbindung zur ersten Halbleiterschicht 21 her.

Im Schutzdiodenbereich 24 weist der Halbleiterkörper eine weitere Ausnehmung 26 auf, die sich durch die zweite Halbleiterschicht 22 und den aktiven Bereich 20 hindurch in die erste Halbleiterschicht 21 erstreckt. Diese weitere Ausnehmung ist für die elektrische Kontaktierung der ersten Halbleiterschicht im Schutzdiodenbereich vorgesehen.

Weiterhin ist zwischen dem Halbleiterkörper 2 und dem Träger 5 eine zweite Anschlussschicht 32 ausgebildet. Die zweite Anschlussschicht 32 dient der elektrischen Kontaktierung der zweiten Halbleiterschicht 22 im Emissionsbereich 23 des Halbleiterchips.

Der Halbleiterchip 1 weist einen ersten Kontakt 41 und einen zweiten Kontakt 42 auf. Die Kontakte sind zur externen elektrischen Kontaktierung des Halbleiterchips vorgesehen. Im Betrieb des Halbleiterchips können durch Anlegen einer elektrischen Spannung zwischen den Kontakten Ladungsträger von verschiedenen Seiten in den aktiven Bereich injiziert werden und dort unter Emission von Strahlung rekombinieren.

In dem gezeigten Ausführungsbeispiel ist der Halbleiterchip 1 von der dem Halbleiterkörper 2 abgewandten Seite des Trägers 5 her über den ersten Kontakt 41 extern elektrisch kontaktierbar. Der erste Kontakt bedeckt eine dem Halbleiterkörper 2 abgewandte zweite Hauptfläche 52 des Trägers bevorzugt vollständig oder zumindest im Wesentlichen vollständig.

Der erste Kontakt 41 ist über den Träger 5 und die Verbindungsschicht 6 elektrisch leitend mit der ersten Anschlussschicht 31 verbunden.

Der zweite Kontakt 42 ist mit der zweiten Anschlussschicht 32 elektrisch leitend verbunden und grenzt vorzugsweise unmittelbar an die zweite Anschlussschicht an. Davon abweichend kann der zweite Kontakt 42 auch mittels einer von außen zugänglichen Fläche der zweiten Anschlussschicht gebildet sein. Eine zusätzliche Kontaktschicht ist für das Ausbilden des Kontakts also nicht notwendigerweise erforderlich.

Im Schutzdiodenbereich 24 ist die erste Halbeiterschicht 21 mit der zweiten Anschlussschicht 32 elektrisch leitend verbunden, wobei sich die zweite Anschlussschicht 32 in der weiteren Ausnehmung 26 von der ersten Halbleiterschicht in Richtung des Trägers 5 erstreckt. Zur Vermeidung eines elektrischen Kurzschlusses des aktiven Bereichs ist im Bereich der weiteren Ausnehmung 26 eine erste Isolationsschicht 71 ausgebildet, welche die Seitenflächen der weiteren Ausnehmung 26 bedeckt.

Weiterhin ist die erste Isolationsschicht 71 im Schutzdiodenbereich 24 zwischen der zweiten Halbleiterschicht 22 und der zweiten Anschlussschicht 32 ausgebildet, so dass ein unmittelbarer elektrischer Kontakt zwischen der zweiten Anschlussschicht und der zweiten Halbleiterschicht im Schutzdiodenbereich vermieden wird.

Die zweite Halbleiterschicht 22 ist im Schutzdiodenbereich 24 elektrisch leitend mit der ersten Anschlussschicht 31 verbunden. Die zweite Anschlussschicht 32 weist eine Aussparung 36 auf, durch die sich die erste Anschlussschicht bis zur zweiten Halbleiterschicht 22 erstreckt.

Zur Vermeidung eines elektrischen Kurzschlusses des aktiven Bereichs 20 im Emissionsbereich 23 ist zwischen den Seitenflächen der Ausnehmungen 25 und der ersten Anschlussschicht 31 eine zweite Isolationsschicht 72 ausgebildet.

Weiterhin verläuft die zweite Isolationsschicht zwischen der ersten Anschlussschicht 31 und der zweiten Anschlussschicht 32. Ein elektrischer Kurzschluss zwischen diesen Anschlussschichten wird so auf einfache Weise vermieden.

Die erste Isolationsschicht 71 und die zweite Isolationsschicht 72 können beispielsweise ein Oxid, etwa Siliziumoxid oder Titanoxid, ein Nitrid, etwa Siliziumnitrid oder ein Oxinitrid, etwa Siliziumoxinitrid enthalten oder aus einem solchen Material bestehen.

Die Mehrzahl von Ausnehmungen 25 dient der in lateraler Richtung gleichmäßigen Injektion von Ladungsträgern über die erste Halbleiterschicht 21 in den aktiven Bereich 20. Die Ausnehmungen 25 können beispielsweise matrixartig oder in Form eines Wabenmusters angeordnet sein. Insbesondere bei hinreichender Querleitfähigkeit der ersten Halbleiterschicht 21 ist auch eine Ausführung des Halbleiterchips denkbar, die im Emissionsbereich lediglich eine einzige Ausnehmung 25 zur elektrischen Kontaktierung der ersten Halbleiterschicht 21 aufweist.

In Aufsicht auf den Halbleiterchip ist die Fläche des Schutzdiodenbereichs 24 vorzugsweise klein gegenüber der Fläche des Emissionsbereichs 23. Insbesondere beträgt die Fläche des Schutzdiodenbereichs höchstens 10 %, besonders bevorzugt höchstens 5 %, am meisten bevorzugt höchstens 1 %, der Fläche des Halbleiterchips 1.

Beispielsweise kann der Halbleiterchip eine Kantenlänge von 1 mm und der Schutzdiodenbereich eine Kantenlänge von 60 µm aufweisen. In diesem Beispiel bedeckt der Schutzdiodenbereich also weniger als 0,4 % der Gesamtfläche des Halbleiterchips, so dass die Integration des Schutzdiodenbereichs in den Halbleiterchip zu keiner signifikanten Verringerung der vom Halbleiterchip abgestrahlten Strahlungsleistung führt.

Bereits bei einer Fläche des Schutzdiodenbereichs 24 von 60 µm x 60 µm ist ein ESD-Schutz, etwa gemäß dem Standard JESD22-A114-E der JEDEC Solid State Technology Association, gegeben und ein ESD-Puls kann nur eine unkritische Temperaturerhöhung verursachen. Die Funktion einer Schutzdiode kann also in überaus kompakter und leicht herzustellender Weise in den Halbleiterchip integriert sein.

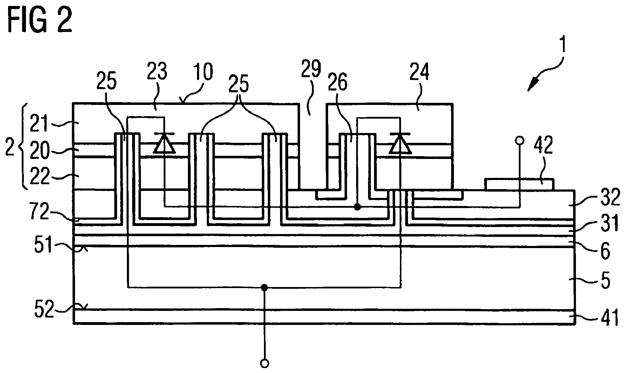

Die Strompfade in dem Halbleiterchip 1 sind in Figur 2 schematisch dargestellt. Nachfolgend werden die Strompfade exemplarisch für den Fall beschrieben, dass die erste Halbleiterschicht n-leitend und die zweite Halbleiterschicht p-leitend ausgeführt ist.

Bei Anliegen einer positiven Spannung am zweiten Kontakt 42 relativ zum ersten Kontakt 41 werden Elektronen vom ersten Kontakt 41 über den Träger 5 und die Verbindungsschicht 6 hindurch über die erste Anschlussschicht 31 in die erste Halbleiterschicht 21 injiziert. Vom zweiten Kontakt 42 werden über die zweite Anschlussschicht 32 Löcher in die zweite Halbleiterschicht 22 des Emissionsbereichs 23 injiziert, so dass die Elektronen und Löcher im aktiven Bereich 20 unter Emission von Strahlung im Emissionsbereich rekombinieren können. Bei dieser Polarität der extern angelegten Spannung wird der Emissionsbereich also in Durchlassrichtung betrieben.

Im Unterschied hierzu ist im Schutzdiodenbereich 24 die erste Halbleiterschicht 21 über die zweite Anschlussschicht mit dem zweiten Kontakt 42 elektrisch leitend verbunden. Weiterhin ist die zweite Halbleiterschicht 22 im Schutzdiodenbereich 24 über die erste Anschlussschicht 31 mit dem ersten Kontakt 41 elektrisch leitend verbunden. Die Durchlassrichtung von Emissionsbereich 23 und Schutzdiodenbereich 24 sind also antiparallel zueinander, so dass der Schutzdiodenbereich 24 bei Anliegen der Betriebsspannung der externen Kontakten 41 und 42 in Sperrrichtung betrieben wird. Somit fließt kein oder zumindest kein wesentlicher Anteil des injizierten Stroms durch den Schutzdiodenbereich 24.

Dagegen kann unerwünschte Spannung, die beispielsweise aufgrund von elektrischer Aufladung im Emissionsbereich 23 in Sperrrichtung am aktiven Bereich 20 anliegt, über den Schutzdiodenbereich 24 abfließen. Somit ist in den Halbleiterkörper 2 die Funktion einer Schutzdiode integriert, die den Emissionsbereich vor Schäden durch elektrostatische Entladung schützt.

Der Halbleiterkörper 2, insbesondere der aktive Bereich 20, enthält vorzugsweise ein III-V-Halbleitermaterial.

III-V-Halbleitermaterialien sind zur Strahlungserzeugung im ultravioletten (InₓGa_{y}Al_{1-x-y}N) über den sichtbaren InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet. Hierbei gilt jeweils 0 ≤ x ≤ 1, 0 ≤ y ≤ 1 und x + y ≤ 1 insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Die erste Anschlussschicht 31 und/oder die zweite Anschlussschicht 32 enthalten vorzugsweise jeweils ein Metall, beispielsweise Titan, Platin, Nickel, Gold, Silber, Aluminium oder Rhodium oder eine metallische Legierung mit zumindest einem der genannten Materialien oder bestehen aus einem Metall oder einer metallischen Legierung. Alternativ oder ergänzend kann die erste Anschlussschicht 31 und/oder die zweite Anschlussschicht 32 ein TCO-Material, beispielsweise ITO oder Zinkoxid, enthalten oder aus einem solchen Material bestehen.

Die zweite Anschlussschicht 32 weist weiterhin bevorzugt für die im aktiven Bereich 20 erzeugte Strahlung eine hohe Reflektivität auf. Im ultravioletten und blauen Spektralbereich eignet sich im Hinblick auf eine hohe Reflektivität beispielsweise Silber, Aluminium oder Rhodium, im roten und infraroten Spektralbereich beispielsweise Gold.

Der erste Kontakt 41 und der zweite Kontakt 42 können insbesondere ein im Zusammenhang mit der ersten und zweiten Anschlussschicht genanntes Metall oder eine metallische Legierung mit einem dieser Materialien enthalten oder aus einem solchen Material bestehen. Insbesondere eigenen sich Materialien, mit denen auf einfache Weise eine externe elektrische Kontaktierung, etwa mittels eines Bonddrahts oder mittels einer Lötverbindung herstellbar ist. Beispielsweise ist Gold als Material für die Kontakte besonders geeignet.

Mittels einer reflektierend ausgebildeten zweiten Anschlussschicht kann die im aktiven Bereich erzeugte und in Richtung des Trägers 5 abgestrahlte Strahlung in Richtung der Strahlungsaustrittsfläche 10 umgelenkt werden und durch diese aus dem Halbleiterchip austreten.

Weiterhin ist der Schutzdiodenbereich 24 außerhalb des Trägers 5 ausgebildet. Durch die Integration der Funktion einer Schutzdiode in den Halbleiterchip werden an den Träger 5 also keine zusätzlichen Anforderungen gestellt. Insbesondere kann der Träger eben und weiterhin vollständig unstrukturiert sein. Die Injektion von Ladungsträgern kann so vom Kontakt flächig durch den Träger hindurch erfolgen.

Als Material für den Träger 5 eignet sich beispielsweise ein Halbleitermaterial, etwa Germanium oder Silizium, das dotiert sein kann.

Die elektrische Kontaktierung der ersten Anschlussschicht 31 mittels des ersten Kontakts 41 und der zweiten Anschlussschicht mittels des zweiten Kontakts 42 erfolgt in dem gezeigten Ausführungsbeispiel lediglich exemplarisch mittels einer Anordnung der Kontakte 41, 42 auf gegenüberliegenden Seiten des Trägers und einer Injektion von Ladungsträgern durch einen elektrisch leitfähigen, unstrukturierten Träger.

Von dem beschriebenen Ausführungsbeispiel abweichend der Träger 5 auch zumindest eine Aussparung aufweisen, die sich in vertikaler Richtung durch den Träger hindurch erstreckt und mit einem elektrisch leitfähigen Material, etwa einem Metall, befüllt ist. In diesem Fall kann der Träger auch elektrisch isolierend ausgebildet sein. Beispielsweise kann der Träger eine Keramik, etwa Aluminiumnitrid, Aluminiumoxid oder Siliziumnitrid enthalten oder aus einem solchen Material bestehen.

Weiterhin kann die vom Halbleiterkörper 2 abgewandte Seite des Trägers 5 vom gezeigten Ausführungsbeispiel abweichend frei von einem elektrischen Kontakt ausgebildet sein. Die elektrischen Kontakte 41, 42 können also auf der dem Halbleiterkörper zugewandten Seite des Trägers angeordnet sein. In diesem Fall ist der Träger vorzugsweise elektrisch isolierend ausgebildet. Davon abweichend kann aber auch ein elektrisch leitfähiger Träger Verwendung finden.

Als weitere Alternative können von dem gezeigten Ausführungsbeispiel abweichend die Kontakte 41, 42 auf der dem Halbleiterkörper 2 abgewandten Seite des Trägers 5 angeordnet sein, so dass der Halbleiterchip ausschließlich von einer Seite des Trägers 5 her elektrisch kontaktierbar ist. Beispielsweise kann in dem Träger für die elektrische Kontaktierung der ersten Anschlussschicht 31 und für die elektrische Kontaktierung der zweiten Anschlussschicht 32 jeweils zumindest eine Aussparung im, vorzugsweise elektrisch isolierend ausgebildeten, Träger 5 vorgesehen sein, die sich jeweils in vertikaler Richtung durch den Träger 5 hindurch erstrecken.

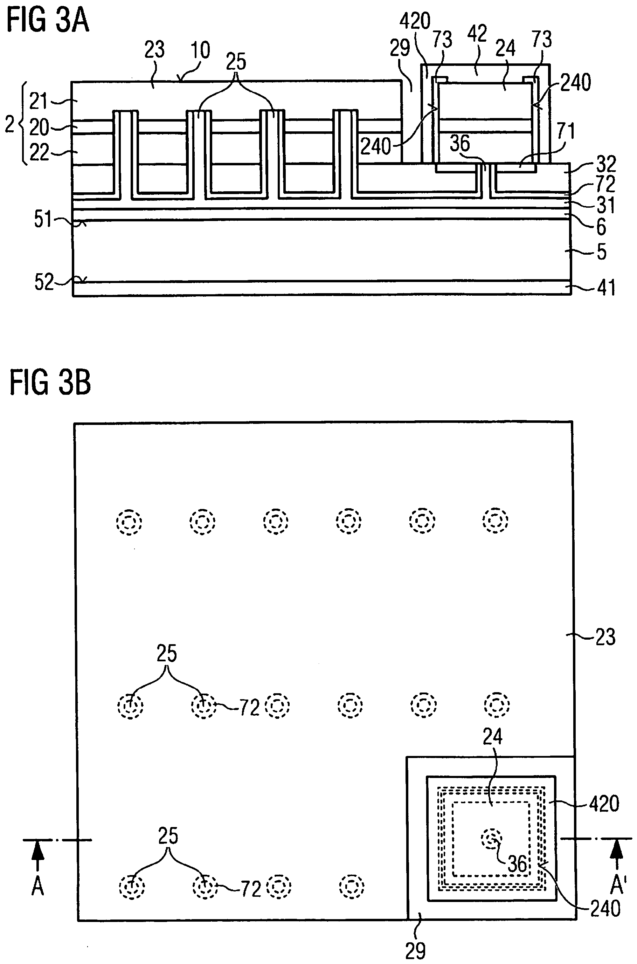

Ein zweites Ausführungsbeispiel für einen Halbleiterchip 1 ist in den Figuren 3A und 3B in schematischer Ansicht gezeigt, wobei die Figur 3B eine Aufsicht und die Figur 3A eine Schnittansicht entlang der Linie AA' darstellt.

Dieses zweite Ausführungsbeispiel entspricht im Wesentlichen dem im Zusammenhang mit den Figuren 1A, 1B und 2 beschriebenen ersten Ausführungsbeispiel. Im Unterschied hierzu ist der zweite Kontakt 42 mittels einer Kontaktschicht 420 gebildet. Der zweite Kontakt 42 ist auf der dem Träger 5 abgewandten Seite des Schutzdiodenbereichs 24 ausgebildet. Hierbei überdeckt der Kontakt 42 den Schutzdiodenbereich 24 in Aufsicht auf den Halbleiterchip.

Die Kontaktschicht 420 bedeckt eine Seitenfläche 240 des Schutzdiodenbereichs 24, die den Schutzdiodenbereich in lateraler Richtung begrenzt.

In dem gezeigten Ausführungsbeispiel umläuft die Kontaktschicht 420 den Schutzdiodenbereich 24 in lateraler Richtung vollständig und bedeckt weiterhin die Seitenflächen 240 des Schutzdiodenbereichs vollständig. Auf diese Weise kann der Schutzdiodenbereich 24 mittels der Kontaktschicht 420 vollständig gekapselt sein. Bei einer Kontaktschicht, die für im aktiven Bereich 20 erzeugte Strahlung undurchlässig ist, kann so vermieden werden, dass Strahlung, die im Schutzdiodenbereich 24 beispielsweise aufgrund elektrostatischer Entladung erzeugt wird, aus dem Halbleiterchip austritt.

Davon abweichend kann die Kontaktschicht 420 die Seitenflächen 240 des Schutzdiodenbereichs 24 auch nur bereichsweise bedecken.

Zwischen der Kontaktschicht 420 und der Seitenfläche des Schutzdiodenbereichs ist eine dritte Isolationsschicht 73 angeordnet. Ein elektrischer Kurzschluss zwischen der ersten Halbleiterschicht 21 und der zweiten Halbleiterschicht 22 im Schutzdiodenbereich 24 durch die Kontaktschicht kann so vermieden werden.

Die Kontaktschicht 420 ist elektrisch leitend mit der zweiten Anschlussschicht 32 verbunden. Somit ist der zweite Kontakt 42 über die Kontaktschicht 420 mit der ersten Halbleiterschicht 21 des Schutzdiodenbereichs 24 und über die zweite Anschlussschicht 32 mit der zweiten Halbleiterschicht 22 des Emissionsbereichs elektrisch leitend verbunden, vorzugsweise jeweils mittels einer ohmschen Verbindung.

Im Unterschied zu dem im Zusammenhang mit den Figuren 1A, 1B und 2 beschriebenen ersten Ausführungsbeispiel ist für die elektrische Kontaktierung der ersten Halbleiterschicht 21 des Schutzdiodenbereichs 24 also im Schutzdiodenbereich keine weitere Ausnehmung erforderlich, die sich durch die zweite Halbleiterschicht 22 und den aktiven Bereich 20 hindurch erstreckt.

Die zweite Halbleiterschicht 22 des Schutzdiodenbereichs 24 ist wie im Zusammenhang mit dem ersten Ausführungsbeispiel beschrieben elektrisch leitend mit der ersten Anschlussschicht und somit über die Verbindungsschicht 6 und den Träger 5 mit dem ersten Kontakt 41 elektrisch leitend, insbesondere mit einer ohmschen Verbindung, verbunden. Somit sind wiederum der Schutzdiodenbereich 24 und der Emissionsbereich 23 bei Anliegen einer externen elektrischen Spannung zwischen dem ersten Kontakt 41 und dem zweiten Kontakt 42 bezüglich ihrer Durchlassrichtung antiparallel zueinander verschaltet.

Die Kontaktschicht 420 kann insbesondere die im Zusammenhang mit den Anschlussschichten 31, 32 genannten Materialien enthalten oder aus einem solchen Material bestehen.

Die Kontaktschicht 420 kann bezüglich des Materials auch von dem Material der zweiten Anschlussschicht 32 verschieden sein. So kann beispielsweise die zweite Anschlussschicht 32 hinsichtlich einer hohen Kontaktfähigkeit zur zweiten Halbleiterschicht 22 und/oder einer hohen Reflektivität für im aktiven Bereich 20 erzeugte Strahlung und die Kontaktschicht 420 hinsichtlich einer guten externen elektrischen Kontaktierbarkeit, beispielsweise mittels einer Drahtbondverbindung, gewählt werden.

Die dritte Isolationsschicht 73 kann insbesondere die im Zusammenhang mit der ersten und der zweiten Isolationsschicht 71 beziehungsweise 72 beschriebenen Materialien enthalten oder aus einem solchen Material bestehen.

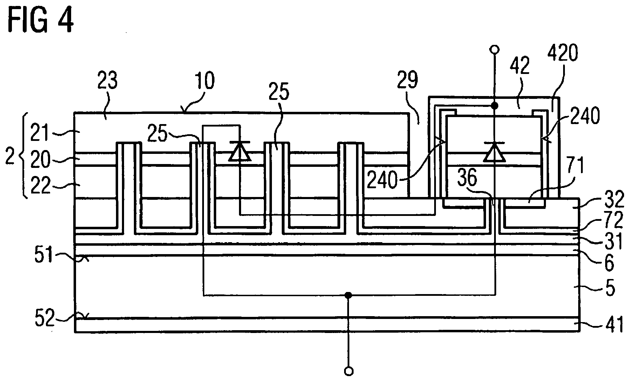

Die Strompfade in einem Halbleiterchip gemäß dem zweiten Ausführungsbeispiel sind in Figur 4 schematisch dargestellt. Hierbei erfolgt die Beschreibung wieder exemplarisch für den Fall, dass die zweite Halbleiterschicht 22 p-leitend dotiert und die erste Halbleiterschicht 21 n-leitend dotiert ist.

Vom ersten Kontakt 41 aus können Ladungsträger zum einen über den Träger 5, die Verbindungsschicht 6 und die erste Anschlussschicht 31 durch die Ausnehmungen 25 im Emissionsbereich 23 in die erste Halbleiterschicht 21 gelangen.

Zum anderen ist der erste Kontakt 41 über den Träger 5, die Verbindungsschicht 6 und die erste Anschlussschicht 31 mit der zweiten Halbleiterschicht 22 des Schutzdiodenbereichs 24 verbunden.

Der zweite Kontakt 42 ist weiterhin über die Kontaktschicht 420 zum einen über die zweite Anschlussschicht 32 mit der zweiten Halbleiterschicht 22 des Emissionsbereichs verbunden und zum anderen ist der Kontakt 42 mit der ersten Halbleiterschicht des Schutzdiodenbereichs 24 elektrisch leitend verbunden.

Bezüglich ihrer Durchlassrichtung sind die Diodenstrukturen des Emissionsbereichs 23 und des Schutzdiodenbereichs 24 somit antiparallel zueinander verschaltet. Bei Anliegen einer positiven elektrischen Spannung am zweiten Kontakt 42 relativ zum ersten Kontakt 41 wird die Diodenstruktur des Emissionsbereichs 23 in Durchlassrichtung betrieben, während der Schutzdiodenbereich 24 in Sperrrichtung betrieben wird.

In dem zweiten Ausführungsbeispiel kann der Schutzdiodenbereich 24 vollständig unterhalb des zweiten Kontakts 42 ausgebildet sein. Auf diese Weise kann die Funktion einer Schutzdiode in den Halbleiterchip 1 integriert werden, ohne dass hierfür zusätzlicher Platz für die Schutzdiode erforderlich ist. Die Schutzdiode ist also unter Beibehaltung der für die Strahlungserzeugung nutzbaren Fläche des Emissionsbereichs 23 in den Halbleiterchip integrierbar.

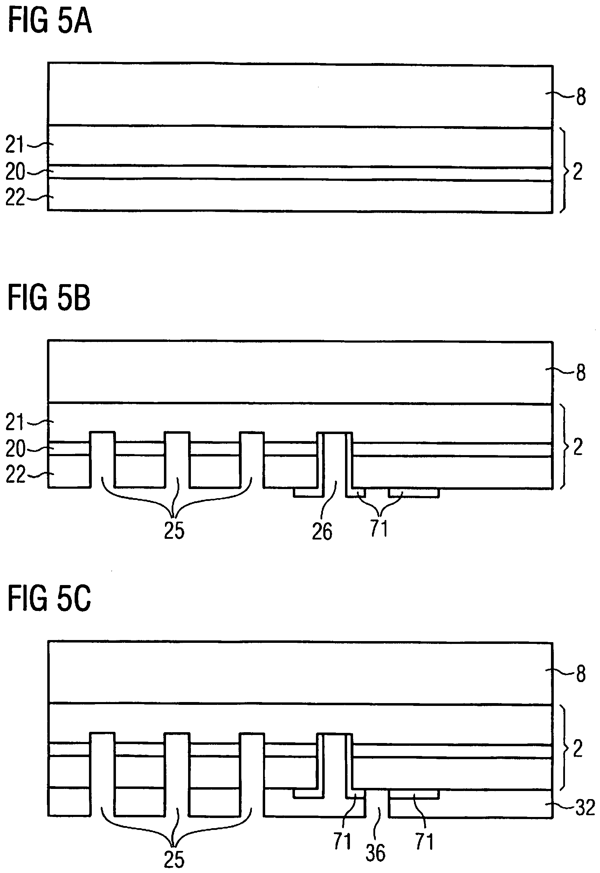

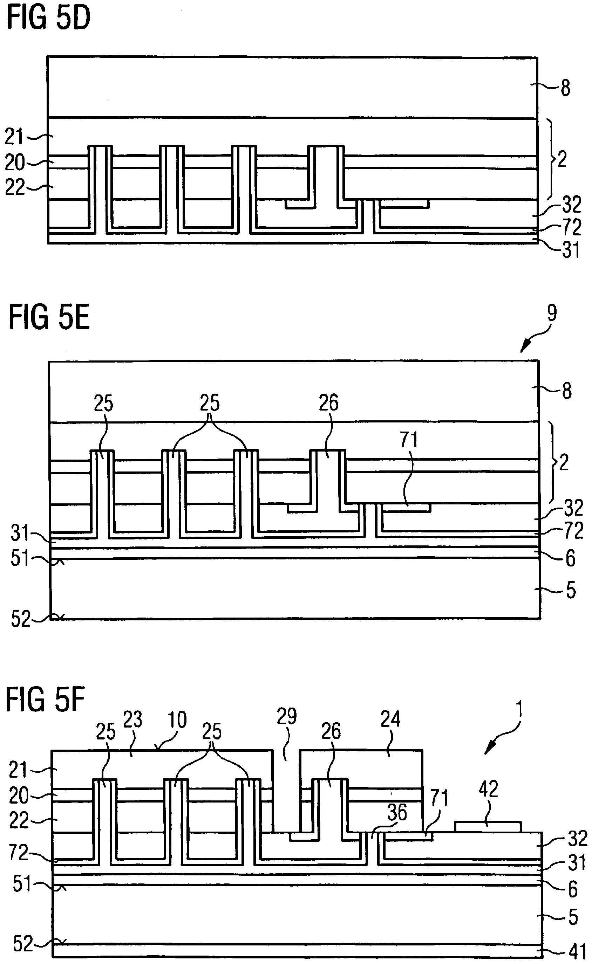

Ein Ausführungsbeispiel für ein Verfahren zur Herstellung eines strahlungsemittierenden Halbleiterchips ist in den Figuren 5A bis 5F anhand von jeweils in schematischer Schnittansicht dargestellten Zwischenschritten gezeigt.

Das Verfahren wird exemplarisch anhand der Herstellung eines Halbleiterchips beschrieben, der wie im Zusammenhang mit Figur 1 beschrieben ausgeführt ist.

Eine Halbleiterschichtenfolge 2 wird bereitgestellt. Die Halbleiterschichtenfolge umfasst einen aktiven Bereich 20, der zwischen einer ersten Halbleiterschicht 21 und einer zweiten Halbleiterschicht 22 angeordnet ist. Die Halbleiterschichtenfolge 2 kann beispielsweise epitaktisch, etwa mittels MOVPE oder MBE abgeschieden werden. Weiterhin kann die Halbleiterschichtenfolge 2 auf einem Aufwachssubstrat 8 für die Halbleiterschichtenfolge bereitgestellt werden. Davon abweichend kann die Halbleiterschichtenfolge 2 auch auf einem vom Aufwachssubstrat verschiedenen Hilfsträger bereitgestellt werden.

Die Halbleiterschichtenfolge bildet in den fertig gestellten Halbleiterchips die Halbleiterkörper.

Wie in Figur 5B dargestellt, werden von der dem Aufwachssubstrat 8 abgewandten Seite der Halbleiterschichtenfolge her Ausnehmungen 25 ausgebildet, die sich durch die zweite Halbleiterschicht 22 und den aktiven Bereich 20 in die erste Halbleiterschicht 21 hinein erstrecken. Dies erfolgt zweckmäßigerweise nach dem Abschluss der Abscheidung der Halbleiterschichtenfolge.

Weiterhin wird eine weitere Ausnehmung 26 im Halbleiterkörper ausgebildet, die sich ebenfalls durch die zweite Halbleiterschicht 22 und den aktiven Bereich 20 hindurch in die erste Halbleiterschicht 21 hineinerstreckt.

Die Ausnehmungen 25 und die weitere Ausnehmung 26 können in einem gemeinsamen Schritt oder nacheinander in verschiedenen Schritten, beispielsweise mittels nasschemischen oder trockenchemischen Ätzens, in der Halbleiterschichtenfolge ausgebildet werden.

Auf der Halbleiterschichtenfolge 2 wird eine erste Isolationsschicht 71 ausgebildet, die die Seitenflächen der weiteren Ausnehmung 26 bedecken. Weiterhin bedeckt die erste Isolationsschicht 71 auch einen Teil der dem Aufwachssubstrat 8 abgewandten Oberseite der Halbleiterschichtenfolge 2.

Wie in Figur 5C dargestellt, wird auf dem Halbleiterkörper 2 nachfolgend eine zweite Anschlussschicht 32 abgeschieden. Die zweite Halbleiterschicht 32 grenzt bereichsweise unmittelbar an die zweite Halbleiterschicht 22 an und erstreckt sich weiterhin durch die weitere Ausnehmung 26 bis zur ersten Halbleiterschicht 21 und stellt eine elektrisch leitende Verbindung mit dieser her. Die Ausnehmungen 25 der Halbleiterschichtenfolge sind dagegen frei von dem Material für die zweite Anschlussschicht 32.

Die erste Anschlussschicht 31 und die zweite Anschlussschicht 32 können beispielsweise mittels Aufdampfens oder Aufsputterns abgeschieden werden.

Auf der zweiten Anschlussschicht 32 wird eine zweite Isolationsschicht 72 abgeschieden, wobei die zweite Isolationsschicht die Seitenflächen der Ausnehmungen 25 bedeckt. Ein an die erste Halbleiterschicht 21 angrenzender Bereich der Ausnehmungen 25, etwa eine Bodenfläche der Ausnehmungen, ist bereichsweise frei von der zweiten Isolationsschicht ausgebildet.

Weiterhin ist die zweite Halbleiterschicht 22 im Bereich einer Aussparung 36 der zweiten Anschlussschicht bereichsweise frei von der zweiten Isolationsschicht.

Nachfolgend wird auf die Halbleiterschichtenfolge 2 eine erste Anschlussschicht 31 abgeschieden, wobei die erste Anschlussschicht die Halbleiterschichtenfolge vollständig oder zumindest im Wesentlichen vollständig bedeckt. Auf eine Strukturierung der ersten Anschlussschicht oder ein strukturiertes Aufbringen der ersten Anschlussschicht kann verzichtet werden.

Die erste Anschlussschicht 31 ist hierbei im Bereich der Aussparung 36 elektrisch leitend mit der zweiten Halbleiterschicht 22 verbunden und im Bereich der Ausnehmungen 25 mit der ersten Halbleiterschicht 21 der Halbleiterschichtenfolge verbunden.

Wie in Figur 5E dargestellt, wird nachfolgend ein Verbund hergestellt, der die Halbleiterschichtenfolge 2, das Aufwachssubstrat 8 und einen Träger 5 umfasst. Der Träger 5 wird stoffschlüssig mittels einer Verbindungsschicht 6 an der Halbleiterschichtenfolge befestigt.

Die Anschlussschichten 31, 32 sind also bereits vor dem Herstellen des Verbunds auf der Halbleiterschichtenfolge ausgebildet.

Der Träger dient der mechanischen Stabilisierung der Halbleiterschichtenfolge 2. Das Aufwachssubstrat 8 ist hierfür nicht mehr erforderlich und kann entfernt werden.

Das Entfernen kann beispielsweise mechanisch, etwa mittels Schleifens, Läppens oder Polierens und/oder chemisch, etwa mittels nasschemischen oder trockenchemischen Ätzens, erfolgen. Alternativ oder ergänzend kann auch ein Laserablöseverfahren verwendet werden.

Wie in Figur 5F dargestellt, wird in der Halbleiterschichtenfolge 2 eine Aussparung 29 ausgebildet, die die Halbleiterschichtenfolge 2 in einen Emissionsbereich 23 und einen Schutzdiodenbereich 24 trennt. Das Ausbilden des Emissionsbereichs und des Schutzdiodenbereichs erfolgt also erst nach dem Ausbilden der ersten und zweiten Anschlussschicht auf der Halbleiterschichtenfolge.

Weiterhin wird ein Bereich der zweiten Anschlussschicht 32 mittels Entfernens des Materials der Halbleiterschichtenfolge 2 freigelegt.

In diesem Bereich kann ein zweiter elektrischer Kontakt 42 auf der zweiten Anschlussschicht 32 abgeschieden werden. Davon abweichend kann auch die Oberfläche der zweiten Anschlussschicht 32 selbst als zweiter Kontakt verwendet werden. Weiterhin wird auf der der Halbleiterschichtenfolge 2 abgewandten Seite des Trägers 5 ein erster Kontakt 41 abgeschieden. Das Abscheiden der Kontakte kann beispielsweise mittels Aufdampfens oder Aufsputterns.

Das Verfahren wurde lediglich zur vereinfachten Darstellung für die Herstellung von nur einem Halbleiterchip beschrieben.

Bei dem Herstellungsverfahren können eine Vielzahl von Halbleiterchips nebeneinander hergestellt werden, wobei die Halbleiterchips durch Vereinzeln des Verbunds 9 aus dem Verbund hervorgehen.

Das Vereinzeln kann beispielsweise mechanisch, etwa mittels Spaltens, Brechens oder Wasserschneidens, chemisch, etwa mittels nasschemischen oder trockenchemischen Ätzens, und/oder mittels Laserstrahlung erfolgen.

Durch das Vereinzeln des Verbunds 9 in Halbleiterchips gehen Halbleiterchips hervor, die jeweils einen Halbleiterkörper 2 mit einem Emissionsbereich 23 und einem Schutzdiodenbereich 24 aufweisen. In den so hergestellten Halbleiterchips ist also bereits beim Vereinzeln mittels des Schutzdiodenbereichs 24 die Funktion einer Schutzdiode in den Halbleiterchip, insbesondere in den Halbleiterkörper, integriert. Der strahlungsemittierende Halbleiterchip ist somit bereits ab dem Vereinzeln vor möglichen Schäden aufgrund elektrostatischer Entladung geschützt.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

## Patentansprüche

1. Strahlungsemittierender Halbleiterchip (1), der einen Träger (5) und einen Halbleiterkörper (2) mit einer Halbleiterschichtenfolge aufweist, wobei
- in dem Halbleiterkörper (2) mit der Halbleiterschichtenfolge ein Emissionsbereich (23) gebildet ist;
- die Halbleiterschichtenfolge einen zur Erzeugung von Strahlung vorgesehenen aktiven Bereich (20) umfasst, der zwischen einer ersten Halbleiterschicht (21) und einer zweiten Halbleiterschicht (22) angeordnet ist;
- die erste Halbleiterschicht (21) auf der dem Träger (5) abgewandten Seite des aktiven Bereichs (20) angeordnet ist;
- der Emissionsbereich (23) eine Ausnehmung (25) aufweist, die sich durch den aktiven Bereich (20) hindurch erstreckt;
- die erste Halbleiterschicht (21) im Emissionsbereich (23) elektrisch leitend mit einer ersten Anschlussschicht (31) verbunden ist, wobei sich die erste Anschlussschicht (31) in der Ausnehmung (25) von der ersten Halbleiterschicht (21) in Richtung des Trägers (5) erstreckt; und
- die zweite Halbleiterschicht im Emissionsbereich mit einer zweiten Anschlussschicht (32) elektrisch leitend verbunden ist, wobei die zweite Anschlussschicht bereichsweise zwischen dem Emissionsbereich und der ersten Anschlussschicht verläuft;
**dadurch gekennzeichnet, dass**
- in dem Halbleiterkörper (2) mit der Halbleiterschichtenfolge ein Schutzdiodenbereich (24) gebildet ist; und
- die zweite Anschlusschicht (32) eine Aussparung (36) aufweist, durch die hindurch die erste Anschlussschicht (31) im Schutzdiodenbereich (24) mit der zweiten Halbleiterschicht (22) elektrisch leitend verbunden ist.

2. Halbleiterchip nach Anspruch 1,
bei dem der Emissionsbereich und der Schutzdiodenbereich bezüglich ihrer Durchlassrichtung antiparallel zueinander verschaltet sind.

3. Halbleiterchip nach Anspruch 1 oder 2,
bei dem der Emissionsbereich und der Schutzdiodenbereich in einer lateralen Richtung nebeneinander angeordnete Bereiche des Halbleiterkörpers sind.

4. Halbleiterchip nach einem der vorhergehenden Ansprüche,
bei dem der Halbleiterkörper stoffschlüssig mit dem Träger verbunden ist und bei dem die erste Anschlussschicht bereichsweise zwischen dem Halbleiterkörper und dem Träger verläuft.

5. Halbleiterchip nach einem der vorherigen Ansprüche,
bei dem die zweite Anschlussschicht im Schutzdiodenbereich elektrisch leitend mit der ersten Halbleiterschicht verbunden ist.

6. Halbleiterchip nach einem der vorherigen Ansprüche,
bei dem der Schutzdiodenbereich eine weitere Ausnehmung (26) aufweist, wobei sich die zweite Anschlussschicht von der ersten Halbleiterschicht in der weiteren Ausnehmung in Richtung des Trägers erstreckt.

7. Halbleiterchip nach einem der vorherigen Ansprüche,
bei dem der Halbleiterchip einen Kontakt (42) aufweist, der für die externe Kontaktierung der zweiten Anschlussschicht vorgesehen ist.

8. Halbleiterchip nach Anspruch 7,
bei dem der Kontakt mittels einer Kontaktschicht (420) gebildet ist, die zumindest bereichsweise eine den Schutzdiodenbereich in lateraler Richtung begrenzende Seitenfläche (240) bedeckt.

9. Halbleiterchip nach Anspruch 8,
bei dem der Kontakt den Schutzdiodenbereich in Aufsicht auf den Halbleiterchip zumindest bereichsweise überdeckt.

10. Halbleiterchip nach Anspruch 7,
bei dem der Kontakt und der Schutzdiodenbereich in Aufsicht auf den Halbleiterchip nebeneinander angeordnet sind.

11. Verfahren zur Herstellung einer Mehrzahl von strahlungsemittierenden Halbleiterchips (1) mit den Schritten:
a) Bereitstellen einer Halbleiterschichtenfolge (2), die einen zur Erzeugung von Strahlung vorgesehenen aktiven Bereich (20) aufweist, der zwischen einer ersten Halbleiterschicht (21) und einer zweiten Halbleiterschicht (22) angeordnet ist;
b) Ausbilden einer Mehrzahl von Ausnehmungen (25), die sich durch die zweite Halbleiterschicht (22) und durch den aktiven Bereich (20) hindurch erstrecken;
c) Ausbilden einer ersten Anschlussschicht (31) auf der Halbleiterschichtenfolge (2), wobei die erste Anschlussschicht (31) in den Ausnehmungen (25) elektrisch leitend mit der ersten Halbleiterschicht (21) verbunden wird und wobei die erste Anschlussschicht (31) bereichsweise mit der zweiten Halbleiterschicht (22) elektrisch leitend verbunden wird; und
d) Ausbilden eines Verbunds (9) mit der Halbleiterschichtenfolge (2) und einem Träger (5); **gekennzeichnet durch** die Schritte
e) Ausbilden einer Mehrzahl von Emissionsbereichen (23) und einer Mehrzahl von Schutzdiodenbereichen (24) aus der Halbleiterschichtenfolge, wobei die Emissionsbereiche (23) jeweils mindestens eine Ausnehmung (25) aufweisen, wobei die zweite Halbleiterschicht in den Emissionsbereichen (23) jeweils mit einer zweiten Anschlussschicht (32) elektrisch leitend verbunden ist, wobei die zweite Anschlussschicht bereichsweise zwischen dem Emissionsbereich und der ersten Anschlussschicht verläuft und wobei die zweite Anschlussschicht (32) Aussparungen (36) aufweist, **durch** die hindurch in den Schutzdiodenbereichen (24) jeweils die erste Anschlussschicht (31) mit der zweiten Halbleiterschicht (22) elektrisch leitend verbunden ist; und
f) Vereinzeln des Verbunds (9) in eine Mehrzahl von Halbleiterchips (1), wobei jeder Halbleiterchip (1) zumindest einen Emissionsbereich (23) und zumindest einen Schutzdiodenbereich (24) aufweist.

12. Verfahren nach Anspruch 11,
bei dem vor Schritt e) ein Aufwachssubstrat (8) für die Halbleiterschichtenfolge zumindest bereichsweise entfernt wird.

13. Verfahren nach Anspruch 11 oder 12,
bei dem eine Mehrzahl von Halbleiterchips gemäß einem der Ansprüche 1 bis 10 hergestellt wird.

## Claims

1. Radiation-emitting semiconductor chip (1) comprising a carrier (5) and a semiconductor body (2) having a semiconductor layer sequence, wherein
- an emission region (23) is formed in the semiconductor body (2) having the semiconductor layer sequence;
- the semiconductor layer sequence comprises an active region (20) provided for generating radiation, said active region being arranged between a first semiconductor layer (21) and a second semiconductor layer (22);
- the first semiconductor layer (21) is arranged on that side of the active region (20) which faces away from the carrier (5);
- the emission region (23) has a recess (25) extending through the active region (20);
- the first semiconductor layer (21), in the emission region (23), is electrically conductively connected to a first connection layer (31), wherein the first connection layer (31) extends in the recess (25) from the first semiconductor layer (21) in the direction of the carrier (5); and
- the second semiconductor layer, in the emission region, is electrically conductively connected to a second connection layer (32), wherein the second connection layer runs in regions between the emission region and the first connection layer;
**characterized in that**
- a protective diode region (24) is formed in the semiconductor body (2) having the semiconductor layer sequence; and
- the second connection layer (32) has a cutout (36) through which the first connection layer (31), in the protective diode region (24), is electrically conductively connected to the second semiconductor layer (22).

2. Semiconductor chip according to Claim 1,
wherein the emission region and the protective diode region are connected in antiparallel with one another with regard to their forward direction.

3. Semiconductor chip according to Claim 1 or 2,
wherein the emission region and the protective diode region are regions of the semiconductor body which are arranged alongside one another in a lateral direction.

4. Semiconductor chip according to any of the preceding claims,
wherein the semiconductor body is cohesively connected to the carrier, and wherein the first connection layer runs in regions between the semiconductor body and the carrier.

5. Semiconductor chip according to any of the preceding claims,
wherein the second connection layer, in the protective diode region, is electrically conductively connected to the first semiconductor layer.

6. Semiconductor chip according to any of the preceding claims,
wherein the protective diode region has a further recess (26), wherein the second connection layer extends from the first semiconductor layer in the further recess in the direction of the carrier.

7. Semiconductor chip according to any of the preceding claims,
wherein the semiconductor chip has a contact (42) provided for the external contact-connection of the second connection layer.

8. Semiconductor chip according to Claim 7,
wherein the contact is formed by means of a contact layer (420), which, at least in regions, covers a side area (240) delimiting the protective diode region in a lateral direction.

9. Semiconductor chip according to Claim 8,
wherein the contact covers the protective diode region at least in regions in a plan view of the semiconductor chip.

10. Semiconductor chip according to Claim 7,
wherein the contact and the protective diode region are arranged alongside one another in a plan view of the semiconductor chip.

11. Method for producing a plurality of radiation-emitting semiconductor chips (1) comprising the following steps:
a) providing a semiconductor layer sequence (2) having an active region (20) provided for generating radiation, said active region being arranged between a first semiconductor layer (21) and a second semiconductor layer (22);
b) forming a plurality of recesses (25) extending through the second semiconductor layer (22) and through the active region (20);
c) forming a first connection layer (31) on the semiconductor layer sequence (2), wherein the first connection layer (31), in the recesses (25), is electrically conductively connected to the first semiconductor layer (21), and wherein the first connection layer (31) is electrically conductively connected in regions to the second semiconductor layer (22); and
d) forming an assemblage (9) comprising the semiconductor layer sequence (2) and a carrier (5); **characterized by** the steps of
e) forming a plurality of emission regions (23) and a plurality of protective diode regions (24) from the semiconductor layer sequence, wherein the emission regions (23) each have at least one recess (25), wherein the second semiconductor layer, in the emission regions (23), is in each case electrically conductively connected to a second connection layer (32), wherein the second connection layer runs in regions between the emission region and the first connection layer, and wherein the second connection layer (32) has cutouts (36) through which, in the protective diode regions (24), the first connection layer (31) is in each case electrically conductively connected to the second semiconductor layer (22); and
f) singulating the assemblage (9) into a plurality of semiconductor chips (1), wherein each semiconductor chip (1) has at least one emission region (23) and at least one protective diode region (24).

12. Method according to Claim 11,
wherein, before step e), a growth substrate (8) for the semiconductor layer sequence is removed at least in regions.

13. Method according to Claim 11 or 12,
wherein a plurality of semiconductor chips according to any of Claims 1 to 10 is produced.

## Revendications

1. Puce semi-conductrice (1) émettant un rayonnement, comportant un support (5) et un corps semi-conducteur (2) ayant une séquence de couches semi-conductrices, dans laquelle
- une zone d'émission (23) est formée dans le corps semi-conducteur (2) comportant la séquence de couches semi-conductrices ;
- la séquence de couches semi-conductrices comprend une zone active (20) prévue pour générer un rayonnement, qui est disposée entre une première couche semi-conductrice (21) et une seconde couche semi-conductrice (22) ;
- la première couche semi-conductrice (21) est disposée sur la face de la zone active (20) qui est tournée à l'opposé du support (5) ;
- la zone d'émission (23) présente un renfoncement (25) qui s'étend à travers la zone active (20) ;
- la première couche semi-conductrice (21) est reliée de manière électriquement conductrice à une première couche de raccordement (31) dans la zone d'émission (23), dans laquelle la première couche de raccordement (31) s'étend dans la direction du support (5) depuis la première couche semi-conductrice (21) dans le renfoncement (25) ; et
- la seconde couche semi-conductrice est reliée de manière électriquement conductrice à une seconde couche de raccordement (32) dans la zone d'émission, dans laquelle la seconde couche de raccordement s'étend par endroits entre la zone d'émission et la première couche de raccordement ;
**caractérisée**
- **en ce qu'**une zone de diodes de protection (24) est formée dans le corps semi-conducteur (2) comportant la séquence de couches semi-conductrices ; et
- **en ce que** la seconde couche de raccordement (32) présente un évidement (36) à travers lequel la première couche de raccordement (31) est reliée de manière électriquement conductrice à la seconde couche semi-conductrice (22) dans la zone de diodes de protection (24).

2. Puce semi-conductrice selon la revendication 1,
dans laquelle la zone d'émission et la zone de diodes de protection sont connectées l'une à l'autre de manière antiparallèle par rapport à leur sens passant.

3. Puce semi-conductrice selon la revendication 1 ou 2,
dans laquelle la zone d'émission et la zone de diodes de protection sont des zones du corps semi-conducteur qui sont disposées côte à côte dans une direction latérale.

4. Puce semi-conductrice selon l'une quelconque des revendications précédentes,
dans laquelle le corps semi-conducteur est relié au support par une liaison par coopération de matières et dans lequel la première couche de raccordement s'étend par endroits entre le corps semi-conducteur et le support.

5. Puce semi-conductrice selon l'une quelconque des revendications précédentes,
dans laquelle la seconde couche de raccordement est reliée de manière électriquement conductrice à la première couche de raccordement dans la zone de diodes de protection.

6. Puce semi-conductrice selon l'une quelconque des revendications précédentes,
dans laquelle la zone de diodes de protection comporte un autre renfoncement (26), dans laquelle la seconde couche de raccordement s'étend dans la direction du support depuis la première couche semi-conductrice dans l'autre renfoncement.

7. Puce semi-conductrice selon l'une quelconque des revendications précédentes,
dans laquelle la puce semi-conductrice comporte un contact (42) qui est prévu pour l'établissement de contacts externes avec la seconde couche de raccordement.

8. Puce semi-conductrice selon la revendication 7,
dans laquelle le contact est formé au moyen d'une couche de contact (420) qui recouvre au moins par endroits une surface latérale (240) délimitant la zone de diodes de protection dans la direction latérale.

9. Puce semi-conductrice selon la revendication 8,
dans laquelle le contact de la zone de diodes de protection recouvre la zone de diodes de protection au moins par endroits dans une vue de dessus de la puce semi-conductrice.

10. Puce semi-conductrice selon la revendication 7,
dans laquelle les contacts de la zone de diodes de protection sont disposés côte à côte dans une vue de dessus de la puce semi-conductrice.

11. Procédé de fabrication d'une pluralité de puces semi-conductrices (1) émettant un rayonnement, comportant les étapes consistant à :
a) fournir une séquence de couches semi-conductrices (2) comportant une zone active (20) prévue pour générer un rayonnement, qui est disposée entre une première couche semi-conductrice (21) et une seconde couche semi-conductrices (22) ;
b) réaliser une pluralité de renfoncements (25) qui s'étendent à travers la seconde couche semi-conductrice (22) et à travers la zone active (20) ;
c) réaliser une première couche de raccordement (31) sur la séquence de couches semi-conductrices (2), dans lequel la première couche de raccordement (31) est reliée de manière électriquement conductrice à la première couche semi-conductrice (21) dans le renfoncement (25) et dans lequel la première couche de raccordement (31) est reliée par endroits de manière électriquement conductrice à la seconde couche semi-conductrice (22) ; et
d) réaliser un composite (9) avec la première séquence de couches semi-conductrices (2) et un support (5) ; **caractérisé par** les étapes consistant à :
e) réaliser une pluralité de zones d'émission (23) et une pluralité de zones de diodes de protection (24) à partir de la séquence de couches semi-conductrices, dans lequel les zones d'émission (23) comportent respectivement au moins un renfoncement (25), dans lequel la seconde couche semi-conductrice est respectivement reliée de manière électriquement conductrice à une seconde couche de raccordement (32) dans les zones d'émission (23), dans lequel la seconde couche de raccordement s'étend par endroits entre la zone d'émission et la première couche de raccordement et dans lequel la seconde couche de raccordement (32) comporte des évidements (36) à travers lesquels la première couche de raccordement (31) est reliée de manière électriquement conductrice à la seconde couche semi-conductrice (22) dans les zones de diodes de protection (24) ; et
f) individualiser le composite (9) en une pluralité de puces semi-conductrices (1), dans lequel chaque puce semi-conductrice (1) comporte au moins une zone d'émission (23) et au moins une zone de diodes de protection (24).

12. Procédé selon la revendication 11,
dans lequel un substrat de croissance (8) est enlevé au moins par endroits pour la séquence de couches semi-conductrices avant l'étape e).

13. Procédé selon la revendication 11 ou 12,
dans lequel on réalise une pluralité de puces semi-conductrices selon l'une quelconque des revendications 1 à 10.
